# EUROPEAN PATENT APPLICATION

(11) **EP 0 849 778 A2**
(43) Date of publication of application: **24.06.1998**
(21) Application number: 97310342.7
(22) Date of filing: 19.12.1997
(51) Int. Cl.: H01L 21/306

(54) **Improvements in or relating to wafer polishing**

(30) Priority: 19.12.1996 US 33680 P
(71) Applicant: Texas Instruments Incorporated, Dallas, Texas 75265 (US)
(72) Inventor: Allen, Franklin Louis, Sherman, TX 75090 (US); Bawa, Mohendra S., Plano, TX (US); L'Anglois, Kenneth John, Sherman, TX 75090 (US); Miller, Palmer Arthur, Sherman, TX 75090 (US); Grimes, Michael H., Plano, TX (US); Simpson, Vikki Sue, Sherman, TX 75090 (US); Etheridge, Gary Lee, Sherman, TX 75090 (US)
(74) Representative: Holt, Michael

(57) **Abstract**

A method for stabilizing the silicon removal rate during chemical-mechanical wafer polishing, the method comprising the steps of circulating a polishing slurry (28) in a chemical-mechanical wafer polishing apparatus (10) and agitating the polishing slurry to adjust both the redox potential and pH of the polishing slurry, to dissolve SiOₓ aggregates in the polishing slurry and to minimize or eliminate the precipitation of SiOₓ aggregates in the polishing slurry.

## Description

### TECHNICAL FIELD OF THE INVENTION

The present invention relates generally to the polishing of wafers during the fabrication of semiconductor devices.

More particularly the present invention relates, to a method for stabilizing the removal rate of silicon from silicon wafers during chemical-mechanical polishing, and in particular to, controlling the reduction-oxidation potential of the siliceous chemical-mechanical silicon polishing slurry during the silicon polishing process.

### BACKGROUND OF THE INVENTION

Without limiting the scope of the invention, its background is described in connection with polishing a semiconductor wafer, as an example.

Heretofore, in this field, chemical-mechanical polishing of silicon wafers has been performed at various stages of device fabrication for planarized irregular top surface topography. For example, in the process for fabricating modern semiconductor integrated circuits, it is necessary to form conductive lines of other structures above previously formed structures. Prior structure formation, however, often leaves the top surface topography of the silicon wafer highly irregular. As a result of these irregularities, deposition of subsequent layers of material could easily result in incomplete coverage, breaks in the deposited material, or voids if it were deposited directly over the aforementioned highly irregular surfaces. If the irregularities are not alleviated at each major processing step, the top surface topography of the surface irregularities will tend to become even more irregular, causing further problems as the layers stack up in the further processing of the semiconductor structure.

Depending upon the type of material used and their intended purposes, numerous undesirable characteristics are produced when these deposition irregularities occur. Incomplete coverage of an insulating oxide layer can lead to short circuits between metalization layers. Likewise, voids can trap air or processing gases, either contaminating further processing steps, or simply lowering overall device reliability. Sharp points on conductors can result in unusual, undesirable field effects. One problem that is widely recognized in the wafer manufacturing process is that, in general, processing high density circuits over highly irregular structures can lead to very poor yields and device performance.

Consequently, it is desirable to affect some type of planarization or flattening of integrated circuit structures in order to facilitate the processing of multi-layer integrated circuits and to improve their yield, performance, and reliability. In fact, all of today's high-density integrated circuit fabrication techniques make use of some method of forming planarized structures at critical points in the fabrication process.

Conventionally, the polishing apparatus used to planarize a semiconductor wafer has been a turntable, often referred to as a rotating platen, and a ring that exerts a constant pressure on the turntable. A polishing pad is typically attached to the upper surface of the turntable. The semiconductor wafer to be polished, is placed on the polishing pad and clamped between the top ring and the turntable. The semiconductor wafer is securably fixed to the lower surface of the top ring by wax, a pad or via suction so that the semiconductor wafer can be rotated integrally with the top ring during polishing.

While the turntable is rotated, a metered stream of slurry from a slurry supply is delivered to the upper surface of the polishing pad. Typically, the slurry is a liquid comprising chemicals and an abrasive. For example, slurry chemistry generally consists of a basic solution having a pH of about 11. This alkaline polishing slurry may also contain fine polishing particles such as colloidal silica (SiO₂).

As wafer manufacturing technology advances, and the demand for more semiconductor containing integrated circuits rises, the semiconductor industry relies more and more on integrated circuits having smaller and smaller wiring patterns. These smaller wiring patterns are interconnected within narrower spaces, requiring improved methods for planarizing the irregular surface topography of silicon wafers. Several parameters have been discovered that affect the quality of chemical-mechanical polishing of silicon wafers. Specifically, mechanical factors such as pressure exerted by the top ring on the turntable and the platen speed affect yield. The chemical factors that affect yield include the type of slurry used, slurry pH, slurry additives, slurry temperature, slurry dilution ratio, slurry batch volume and volumetric flow rate. Each of the mechanical and chemical factors contribute to the quality of the planarized surface on the silicon wafer, which concomitantly affects the yield, at each step, of semiconductor integrated circuit process.

More specifically, it has been discovered that the silicon removal rate during the planarization process is directly related to the reduction-oxidation potential of the siliceous chemical-mechanical silicon polishing slurry. Therefore, what is needed is a method to stabilize the silicon removal rate by controlling the reduction-oxidation potential of the slurry during the chemical-mechanical polishing process. Controlling the reduction-oxidation potential of the slurry not only stabilizes the silicon removal rate during polishing, but also, increases the useful life of the polishing slurry, allowing for greater recirculation of the polishing slurry. The longer slurry life results in both cost savings from the decreased use of slurry batches, as well as a reduced environmental impact from the discarded volumes of polishing slurry.

### SUMMARY OF THE INVENTION

The present invention disclosed herein comprises a method to stabilize the silicon removal rate of a polishing slurry during chemical-mechanical wafer polishing. The method comprises controlling the reduction-oxidation (redox) potential of the polishing slurry in order to increase the efficiency in both quality and yield of the wafer polishing process. The method also comprises controlling both the pH and the temperature of the polishing slurry to further increase the efficiencies. In addition to increased quality and yield of semiconductor wafers, the method of the present invention increases the recycling and reuse of each batch of polishing slurry, saving money and decreasing the environmental impact of spent polishing slurry.

One aspect of the present invention is a method of reducing the change in the redox potential of a polishing slurry. In general the method comprises recirculating a polish slurry in a chemical-mechanical wafer polishing apparatus and agitating the polishing slurry to control the redox potential. The method may also include monitoring the redox potential of the polishing slurry and adding a reducing or oxidating agent to the slurry. The redox potential of the slurry can be adjusted through the use of a reducing agent, whose introduction into the slurry recirculating system is controlled by determining the relative redox potential of the polish slurry in at least one point in the recirculating system. Alternatively, if the slurry is in need of oxidation, an oxidating agent can be added to the polishing slurry. The redox potential of the slurry can be measured using, for example, a platinum redox electrode with a Silver/Silver Chloride reference electrode. The release of a reducing or an oxidizing agent from a redox agent reservoir is controlled by the user or via a redox controller whose output is designed to respond to the input redox potential of the slurry.

Several oxidizing and several reducing agents may be used. Examples of oxidants that may be used to lower the redox charge, include Cl₂, O₂, Br₂, I₂ and NaOCl. With the use of Cl₂, Br₂, and I₂ any bacterial growth in the slurry is minimized due to the biocide effect of these oxidizing agents. To reduce the polishing slurry, reducing agents such as SO₂, Na₂SO₃, or NaHSO₃ may be used. The reducing agent may be added to the polishing slurry in an inert gas atmosphere consisting of, for example, N₂ or Ar, to prevent contact with air which decreases the effectiveness of the reducing agents. The Nernst equation may be used to calculate the relative contribution of the oxidizing and reducing agents.

Another aspect of the present invention is a method of maintaining the pH buffering capacity of a polishing slurry. In general the method comprises monitoring the pH of the polishing slurry and adding an alkaline agent to the slurry. The slurry pH can be adjusted through the use of alkalis, whose introduction into the slurry recirculating system is controlled by a pH control system that monitors the pH of the slurry in at least one point in the recirculating system. The release of the alkaline agent from an agent reservoir may be controlled by a pH controller whose output is designed to respond to the input pH from a pH probe or probes disposed to read slurry pH.

In the chemical-mechanical polishing process of silicon wafers, the polishing slurry commonly contains water dispersed with 20 to 100 nanometer silica particles that are stabilized by sodium cations. The hydration of the surface of the silicon particles by water molecules and the surrounding cloud of cations stabilize the slurry against aggregation or coagulation, settling-out, gelling and precipitation. The range of silica (SiO₂) to soda (Na₂O) ratio, however, increases with the use of the slurry in the polishing process. The increase in silica to soda ratio destabilizes the slurry resulting in silicate aggregation and precipitation from the slurry. The aggregates and precipitates interfere with the polishing process in a variety of ways, which ultimately result in polish defects.

As the silica to soda ratio changes, the pH of the polishing slurry decreases, causing a reduction in the buffer capacity of the polishing slurry. Agents must therefore be combined into the polishing slurry to increase the pH of the polishing slurry. The agents are preferably selected from the chemical family known as the alkalis which are among the strongest known bases. Preferably the alkalis used are sodium hydroxide (NaOH) and potassium hydroxide (KOH).

The increase in silica to soda ratio destabilizes the slurry resulting in silicate aggregation and precipitation from the slurry, leading to changes in both pH and redox potential. As the silica to soda ratio changes, the redox potential of the polishing slurry changes, causing a reduction in effectiveness of the polishing slurry. Agents may be combined into the polishing slurry to adjust the redox potential of the polishing slurry, thereby increases the effective slurry lifetime.

The addition of oxidizing agents in a suitable amount, helps to reduce the rate of redox potential decay that occurs during polishing runs. An example of a preferred redox potential for a fresh polishing slurry is about -75.3 millivolts. As the polishing process continues, samples may be taken during or at the end of a polishing run to determine the amount of change in the redox potential. Agents can then be added to restore the redox potential, and to restore the pH. As the redox potential is directly affected by the pH of the solution, both the pH and the redox potential may be adjusted concurrently, or in steps, in order to adjust both the pH and the redox potential of the polishing slurry. Furthermore, the change in redox potential may help dissolve silicon oxide aggregates or precipitates in the polishing slurry. Therefore, the addition of oxidizing agents minimizes or eliminates the precipitation of silicon oxides (SiOₓ) from the polishing slurry, thereby preventing further degradation of the polishing slurry.

In another aspect of the present invention, a method is disclosed herein that comprises recirculating a polish slurry in a chemical-mechanical wafer polishing apparatus and monitoring the temperature of the polishing slurry at a point in the slurry recirculation system. The slurry temperature is maintained through the use of both a heating and a cooling mechanism comprising shell and tube heat exchangers or heating and cooling coils that are controlled by a controller whose output is designed to respond to the input temperature from the temperature probe or probes disposed to read slurry temperature.

### DESCRIPTION OF THE DRAWINGS

The present invention will now be further described by way of example, with reference to the accompanying drawings in which:
Figure 1 is a simplified illustration of a wafer polishing apparatus showing a redox potential control chamber and a pH control chamber;
Figure 2 is a simplified illustration of a wafer polishing apparatus showing a redox potential control chamber in combination with a pH control chamber;
Figure 3 is a flow diagram of a method of the present invention; and
Figure 4 is a flow diagram of a method of the present invention.

Corresponding numerals and symbols in different figures refer to corresponding parts unless otherwise specified.

### DETAILED DESCRIPTION OF THE INVENTION

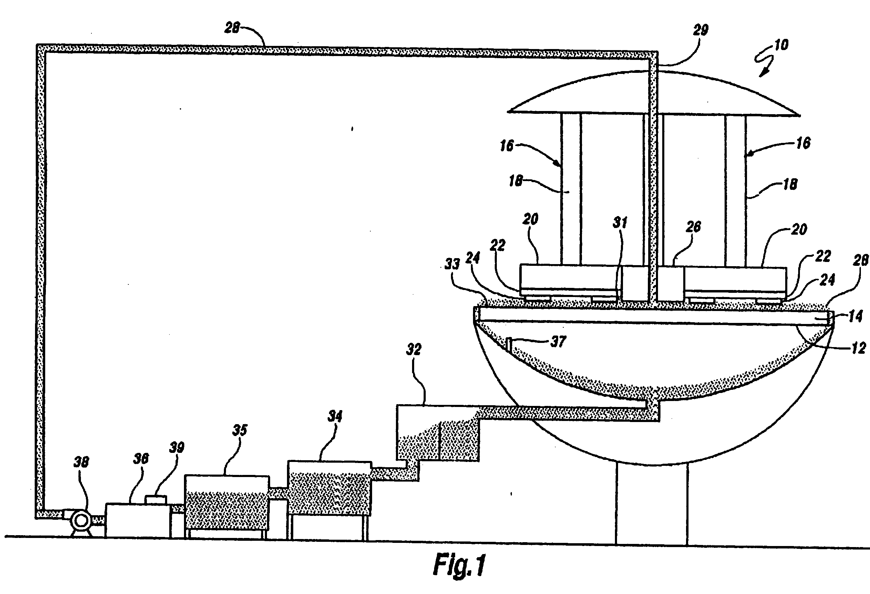

In Figure 1, an apparatus for chemical-mechanical polishing of various work pieces, such as semiconductor wafers, is generally depicted as 10. The polishing apparatus 10 includes a lower platen 12 having a polishing pad 14 attached thereto on the upper surface of the lower platen 12. The polishing apparatus 10 may include a plurality of polishing units 16. Each polishing unit 16 includes a shaft 18, an upper platen 20, and a carrier plate 22. Each polishing unit 16 holds at least one semiconductor wafer 24.

In operation, the lower platen 12 and the polishing unit 16 are counter rotated such that the lower surface of the semiconductor wafers 24 contacts the upper surface of the polishing pad 14. The polishing units 16 are rotated by friction generated between the polished surface of semiconductor wafer 24 and polishing pad 14. The lower platen 12 and the upper platens 20 both rotate counterclockwise while the center drive 26 rotates clockwise while evenly distributing slurry 28 across polishing pad 14 through a circular gap between center drive 26 and polishing pad 14. The slurry 28 provides for both chemical and mechanical polishing of the silicon wafers 24.

The slurry 28 may contain particles of silica of the order of 20 to 100 nanometers in diameter. The slurry 28 also contains sodium cations to stabilize the slurry. The hydration of the surface of the silica particles by water molecules and the surrounding cloud of sodium cations stabilize the slurry 28 against coagulation, settling-out, gelling, and precipitation. The range of silica to soda ratio, however, increases with the use of the slurry 28 in the polishing apparatus 10. The increase in the silica to soda ratio destabilizes the slurry 28 and results in the aggregation and precipitation of the silica colloidal particles from the slurry 28, which further changes the silica to soda ratio. The aggregates and precipitates interfere with the polishing process and produce polish defects.

The buffer capacity of the slurry 28 has been empirically derived. The calculations of the buffering capacity show that the buffering capacity of silicic acid is maximum in the pH range of 9.7 to 11.7, which corresponds to the pKa of the first and the second dissociation constants of the silicic acid. The buffering capacity of any acid and its conjugate base is maximal at a pH corresponding to pKa and becomes less for values of pH either more acidic or more basic. For example, the use of 7.3 grams of soda, which corresponds to 1.2 X 10⁻² moles/liter OH concentration, in a typical 20 liter batch of slurry containing 685 grams of silica assures substantial practical buffering index for the first three runs of the six run slurry batch.

Experimentally it has been found that compared to an ideal value of 0.25, the buffering index after the first run was 0.20, the buffering index after the second run was 0.14, and the buffering index for the third run was 0.10. After the fourth, fifth and sixth runs, the buffering index drops below 0.10 to 0.08, 0.07 and 0.06, respectively. The progressive neutralization of the slurry 28 and corresponding reduction in the buffering index are a result of the self-dissociation of the water, the dissociation of silicic acid, the electrical neutrality of the slurry and the conservation of the added silicon introduced into the slurry 28 as a result of polishing the silicon wafers 24.

The progressive neutralization of slurry 28 is counteracted by combining an agent into the slurry 28 to adjust the pH. Combining the agent with slurry 28 maintains the pH of slurry 28 within the predetermined range, thereby maintaining the buffer capacity of the slurry 28, and preventing the problems caused by a change in the pH of the slurry 28.

In one embodiment, the agent combined with slurry 28 is an alkali such as sodium hydroxide (NaOH) or potassium hydroxide (KOH). The addition of one of these alkalis allows the pH of the slurry 28 to be maintaining between about 9.7 and 11.7. The addition of the alkalis dissolves any silicon oxide aggregates in the slurry 28 and minimizes or eliminates precipitation of silicon oxide in the slurry 28.

The alkali may be introduced into the slurry 28 in a pH control chamber 34. The necessity for and the amount of agent introduced into the slurry 28 in a pH control chamber 34 may be determined from slurry samples taken at strategic locations throughout the circulation path of the slurry 28. For example, pH may be tested proximate to the center drive 26, in the defoaming chamber 32, or in the pH control chamber 36. The alkalis may be introduced in the pH control chamber 36 from an agent reservoir (not pictured). After the slurry 28 passes through the pH control chamber 34, a pump 38 circulates the slurry 28 back to the surface of the polishing pad 14.

The calculations of the redox potential show that the redox potential of polishing slurry 28 is at its maximum when the slurry 28 is fresh, that is, before its first use. An example of the variation in redox potential and pH for a six run polishing cycle is presented in table 1.

**Table 1**

| Slurry | pH | Redox (mV) Potential |
|---|---|---|
| Initial | 10.7 | -75.3 |
| Run 1 | 10.1 | -56.0 |
| Run 2 | 10.0 | -48.1 |
| Run 3 | 9.9 | -40.2 |
| Run 4 | 9.8 | -34.1 |
| Run 5 | 9.7 | -12.3 |
| Run 6 | 9.5 | +52.0 |

A typical redox potential value may be about -75.3 millivolts, which corresponds to the redox potential of the slurry using a platinum redox electrode with a Silver/Silver Chloride reference electrode at room temperature. At the same time, the pH of the slurry was found to be 10.7, which corresponds to the pKa of the first and the second dissociation constants of the silicic acid. After the first run, the redox potential of slurry 28 was -56.0 millivolts. After subsequent runs, the redox potential was -48.1, -40.2, -34.1, -12.3 and +52.0 millivolts, respectively.

During the initial five runs, the redox potential remained in the negative range. The redox potential following the sixth run, however, has changed completely, as the pH has dropped from an initial pH of 10.7 to a pH of 9.5 at the end of the sixth run. The progressive, and then rapid change in the redox potential of the slurry 28 corresponds to a reduction in the buffering index and pH of the slurry, and is a result of the self-dissociation of the water, the dissociation of silicic acid, the electrical neutrality of the slurry and the conservation of the added silicon introduced into the slurry 28 as a result of polishing the silicon wafers 24.

It is preferred that slurry 28 enter a redox potential control chamber 35 in which slurry 28 is agitated in order to dissolve SiOₓ aggregates in the polishing slurry 28 to minimize or eliminate the precipitation of SiOₓ aggregates into the polishing slurry 28. The agitation in redox potential control chamber 35 may be achieved with a variety of conventional mechanisms including, but not limited to, a rotating agitator disposed within redox potential control chamber 35 or by a shaker mechanism which vibrates redox potential control chamber 35.

However, the progressive neutralization of slurry 28 may also be counteracted by combining an agent into the slurry 28 to adjust the redox potential. Combining the agent with slurry 28, reduces the rate of decay of the redox potential of slurry 28, thereby maintaining the redox potential of the slurry 28, and preventing the problems caused by a change in the redox potential of the slurry 28.

The agents that may be combined to regulate the redox potential may be either oxidants or reducing agents. For use with the method of the present invention several oxidizing, and several reducing agents may be used. Examples of oxidants that may be used to lower the redox charge, include Cl₂, O₂, Br₂, I₂ and NaOCl. With the use of Cl₂, Br₂, and I₂ any bacterial growth in the slurry is minimized due to the biocide effect of these oxidizing agents. To reduce the polishing slurry, reducing agents such as SO₂, Na₂SO₃, or NaHSO₃ may be used. The reducing agent may be added to the polishing slurry in an inert gas atmosphere consisting of, for example, N₂ or Ar, to prevent contact with air which decreases the effectiveness of the reducing agents. The Nernst equation may be used to calculate the relative contribution of the oxidizing and reducing agents.

The necessity for and the amount of an oxidizing, or a reducing agent, that is needed to maintain the redox potential of the slurry 28 in a redox control chamber 35 may be determined from slurry samples taken at strategic locations throughout the circulation path of the slurry 28. For example, redox potential may be tested proximate to the center drive 26, in the defoaming chamber 32, or in a pH control chamber 34. The oxidizing or reducing agents may be introduced in the redox potential control chamber 35 from an agent reservoir (not pictured). After the slurry 28 passes through the redox potential control chamber 35, a pump 38 circulates the slurry 28 back to the surface of the polishing pad 14.

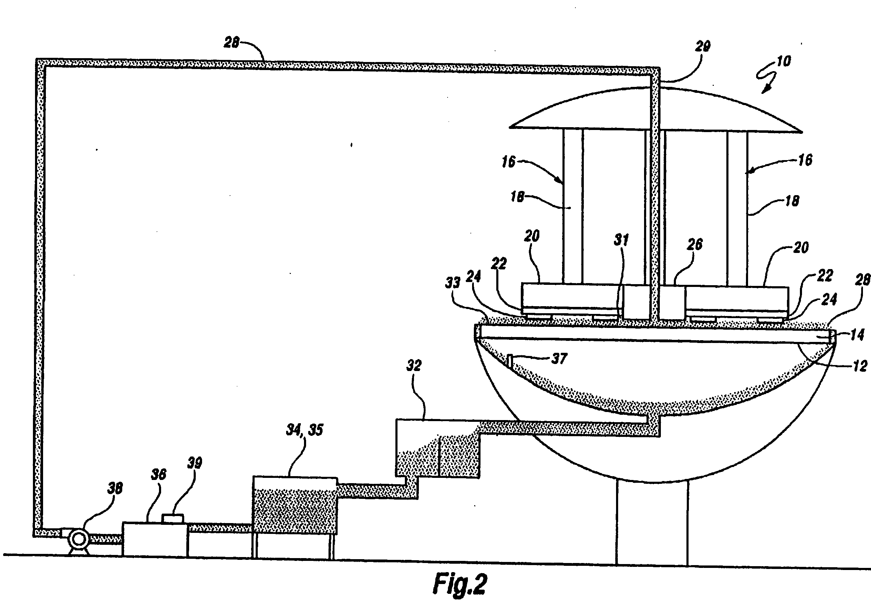

Figure 2 depicts an alternative embodiment in which the redox control chamber 35 may be used concomitantly with a pH control chamber 34. As the pH and the redox potential are related, it may be desirable to adjust both the pH and the redox potential of the slurry 28 together. Also, it may only be necessary to change the pH and the redox potential of the slurry 28 at the end of a particular production run. In this embodiment, the slurry may be tested for changes in both pH and redox potential following a production run, rather that continuously. For example, while wafers are being unloaded from and/or loaded on the polishing apparatus 10, the pH and the redox potential may be analyzed and adjusted to reach optimal ranges.

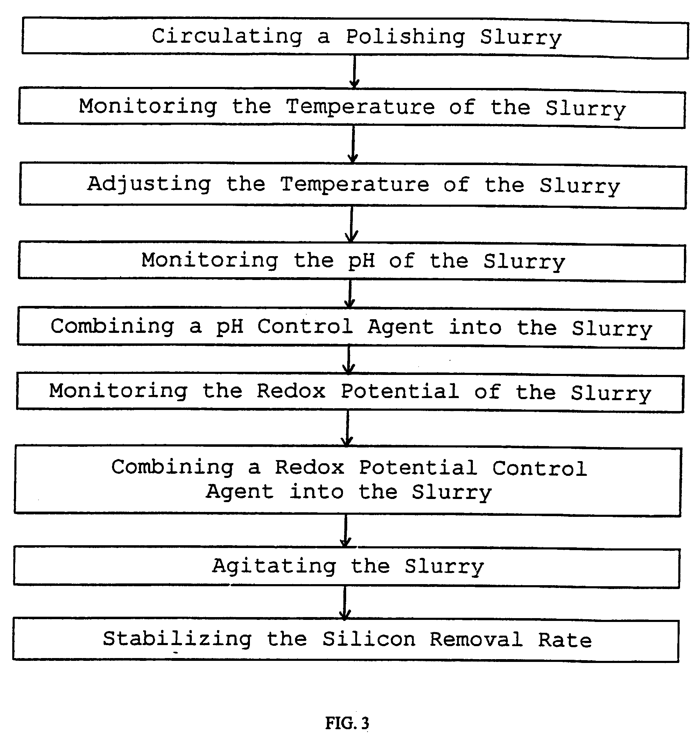

Figure 3 is a flow diagram showing a method for stabilizing the silicon removal rate during chemical-mechanical wafer polishing. In this method, polishing slurry 28 is circulated as the lower platen 12 and the upper platen 20 rotate relative to one another with the silicon wafer 24 disposed there between. The combination of the polishing pad 14 that is disposed above the lower platen 12 and the circulating slurry 28 polishes the back surface of the wafer 24.

As the polishing process progresses, changes occur to slurry 28. For example, the redox potential of slurry 28 increases, slurry 28 is neutralized due to, among other things, the silicon introduced into the slurry 28 as a result of the polishing process, and the temperature of slurry 28 is increased. Each of these changes affects the silicon removal rate during polishing of the silicon wafer.

In order to stabilize the silicon removal rate, the redox potential, the pH and the temperature of slurry 28, is monitored and adjusted. For example, once the redox potential of slurry 28 is determined, slurry 28 may be agitated in redox potential control chamber 35. Alternatively, or in addition to the agitation process, one or more redox potential control agents may be added to slurry 28. Similarly, once the pH of slurry 28 is determined, an agent may be combined to slurry 28 in pH control chamber 34. The quantity of the redox potential control agents and the pH control agents required to stabilize slurry 28 is determined by monitoring the redox potential and the pH of slurry 28. The addition of redox potential control agent into slurry 28 results in a dissolving of silicon oxide aggregates or precipitates in polishing slurry 28. Also, once the appropriate amount of pH control agent is added to slurry 28, the pH of slurry 28 is maintained between about 9.7 and 11.7 and preferably about 11. The temperature of slurry 28 is controlled in temperature control chamber 36. By monitoring and controlling the redox potential, the pH, and the temperature of slurry 28, the silicon removal rate during the chemical-mechanical wafer polishing process is stabilized.

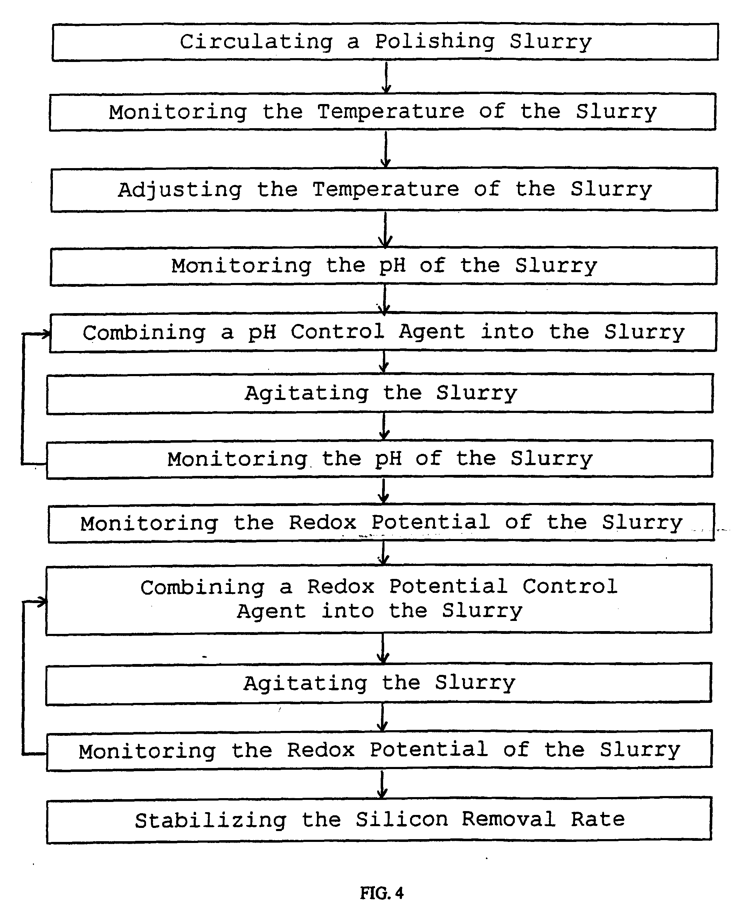

Figure 4 is a flow diagram showing an alternate method for stabilizing the silicon removal rate during chemical-mechanical wafer polishing, for a batch operation. In this method, once slurry 28 passes over lower platen 12, slurry 28 may enter a single chamber (not pictured) or several chamber similar to pH control chamber 34 or redox potential control chamber 35. The temperature of slurry 28 may then be monitored and adjusted until the temperature slurry 28 reaches an ideal level. The pH of slurry 28 may then be monitored and adjusted until the pH of slurry 28 reaches an ideal level. Then the redox potential of slurry 28 may be monitored and adjusted until the redox potential of slurry 28 reaches an ideal level. Slurry 28 is then ready to be circulated through polishing apparatus 10. By monitoring and controlling the redox potential, the pH, and the temperature of slurry 28, the silicon removal rate of chemical-mechanical wafer polishing is stabilized in a batch process.

While the invention has been described with reference to certain illustrative embodiments, this description should not be construed in a limiting sense. Various modifications and combinations of the illustrative embodiments as well as other embodiments will be apparent to those of skill in the art upon reference to the description.

## Claims

1. A method for stabilizing silicon removal rate during chemical-mechanical wafer polishing, the method comprising:
circulating a polishing slurry in a chemical-mechanical wafer polishing apparatus; and
agitating the polishing slurry to adjust the redox potential of the polishing slurry.

2. The method of Claim 1 wherein the step of agitating the polishing slurry is arranged to dissolve SiOₓ aggregates in the polishing slurry.

3. The method of Claim 1 or Claim 2, wherein the step of agitating the polishing slurry is arranged to minimize the precipitation of SiOₓ aggregates in the polishing slurry.

4. The method of any of Claims 1 to 3 further comprising the steps of:
monitoring the redox potential of the polishing slurry; and
introducing an agent into the polishing slurry to adjust the redox potential of the polishing slurry.

5. The method of Claim 4, wherein the step of introducing an agent into the polishing slurry to adjust the redox potential of the polishing slurry comprises introducing a reducing agent into the polishing slurry.

6. The method of Claim 5, wherein the step of introducing an agent into the polishing slurry to adjust the redox potential of the polishing slurry comprises introducing a reducing agent selected from the group consisting SO₂, Na₂SO₃, or NaHSO₃.

7. The method of Claim 4, wherein the step of introducing an agent into the polishing slurry to adjust the redox potential of the polishing slurry comprises introducing an oxidizing agent into the polishing slurry.

8. The method of Claim 7, wherein the step of introducing an agent into the polishing slurry to adjust the redox potential of the polishing slurry comprises introducing an oxidizing agent selected from the group comprising: Cl₂, O₂, Br₂, I₂ and NaOCl.

9. The method of any of Claims 1 to 8, wherein the step of agitating the polishing slurry comprises agitating the slurry in an inert gas atmosphere.

10. A method for stabilizing silicon removal rate during chemical-mechanical wafer polishing, the method comprising:
circulating a polishing slurry in a chemical-mechanical wafer polishing apparatus;
monitoring a redox potential of the polishing slurry; and
introducing an agent into the polishing slurry to adjust the redox potential of the polishing slurry.

11. The method of Claim 10 further comprising the steps of:
monitoring a pH value of the polishing slurry and introducing an agent into the polishing slurry to adjust the pH valve of the polishing slurry.

12. The method of Claim 11, wherein the step of introducing an agent into the polishing slurry to adjust the pH value of the polishing slurry comprises introducing an alkali into the polishing slurry.

13. The method of Claim 12, wherein the step of introducing an alkali into the polishing slurry comprises introducing an alkali selected from the group comprising:sodium hydroxide and potassium hydroxide.

14. The method of any of Claims 11 to 13, further comprising the step of:
maintaining the pH value of the polishing slurry between about 9.7 and 11.7.

15. The method of any of Claims 10 to 14, further comprising the step of:
agitating the polishing slurry to adjust the redox potential of the polishing slurry.

16. The method of Claim 15 wherein the step of agitating the polishing slurry is arranged to dissolve SiOₓ aggregates in the polishing slurry.

17. The method of Claim 15 or Claim 16, wherein the step of agitating the polishing slurry is arranged to minimize the precipitation of SiOₓ aggregates in the polishing slurry.

18. The method of any of Claims 15 to 17, wherein the step of agitating the polishing further comprises agitating the polishing slurry in an inert gas atmosphere.

19. A method for stabilizing a silicon removal rate during chemical-mechanical wafer polishing, the method comprising:
circulating a polishing slurry in a chemical-mechanical wafer polishing apparatus;
monitoring a temperature of the polishing slurry;
exposing the polishing slurry to a temperature control element for adjusting the temperature of the polishing slurry;
agitating the polishing slurry to adjust a redox potential of the polishing slurry;
monitoring the redox potential of the polishing slurry; and
introducing an agent into the polishing slurry to adjust the redox potential of the polishing slurry.

20. The method of Claim 19 further comprising the steps of:
monitoring a pH value of the polishing slurry; and
introducing an agent into the polishing slurry to adjust the pH value of the polishing slurry.
